# FASCICULE DE BREVET EUROPEEN

(11) **EP 1 212 831 B1**
(45) Date de publication et mention de la délivrance du brevet: **14.05.2003**
(21) Numéro de dépôt: 00962645.8
(22) Date de dépôt: 14.09.2000
(51) Int. Cl.: H03F 3/181, H03F 1/04, H03F 5/00

(54) **DISPOSITIF PREAMPLIFICATEUR ADAPTATEUR D'IMPEDANCE POUR AUDIOFREQUENCES A TUBES ELECTRONIQUES INSERABLE EN LIGNE SUR LE TRAJET DU SIGNAL BASSES FREQUENCES**
VORRICHTUNG ZU EINEM IMPEDANZANPASSENDEN RÖHRENVERSTÄRKER FÜR AUDIOSIGNALE ZUM EINFÜGEN IN EINEN SIGNALWEG
IMPEDANCE ADAPTING AMPLIFIER DEVICE FOR LOW FREQUENCY WITH ELECTRONIC TUBES INSERTIBLE ON LINE IN THE PATH OF THE LOW FREQUENCY SIGNAL

(30) Priorité: 15.09.1999 FR 9911524
(43) Date de publication de la demande: 12.06.2002
(73) Titulaire: Girard, Nicolas, 75013 Paris (FR)
(72) Inventeur: Girard, Nicolas, 75013 Paris (FR)
(86) Numéro de dépôt international: FR0002552
(87) Numéro de publication internationale: WO01020777

(56) Documents cités:
- EP-A- 0 862 260
- US-A- 2 918 630
- US-A- 2 965 853
- US-A- 3 743 954
- US-A- 4 673 888
- US-A- 5 343 159
- US-A- 5 834 977

## Description

L'invention se rapporte à un dispositif amplificateur adaptateur d'impédance pour audiofréquences à tubes électroniques insérable en ligne sur le trajet du signal basses fréquences.

En électronique basses fréquences, il est connu que l'adaptation d'impédance est couramment effectuée sans interface particulière entre les différents maillons de la chaîne de traitement du signal. En effet dans la majorité des cas, l'impédance de l'étage de sortie de «l'émetteur» et l'impédance de l'étage d'entrée du «récepteur» sont égales, gage en théorie de la meilleure transmission de puissance, au détriment cependant des résultats auditifs qui sont généralement qualifiés de médiocres par les mélomanes.

Couramment les chaînes de traitement du signal basses fréquences comme les studios d'enregistrements, les installations de régie (mobiles ou non), les dispositifs de prise de son, les «boucles de monitoring», les installations haute fidélité de contrôle, les installations haute fidélité domestiques, les installations haute fidélité au sein des véhicules (terrestres, aériens et maritimes), les installations haute fidélité de "Home cinéma", les installations haute fidélité issues des ordinateurs, des stations multimédia (c'est à dire qui comprennent une sortie audio et des enceintes ou consoles de contrôle) sont soumises aux problèmes d'adaptation d'impédance décrit plus haut, de manière d'autant plus importantes que ces "chaînes de traitement du signal basses fréquences" sont composées de maillons actifs tous reliés dans la majorité des cas par de très importantes longueurs de câble, engendrant une baisse très sensible du niveau de qualité du signal basse fréquence à traiter par la présence de "pertes d'insertion" et de "capacités parasites" d'autant plus importante que les câbles reliants les différents éléments de ces "chaînes de traitement du signal" sont longs.

De plus dans tout ces cas ou un dispositif adaptateur d'impédance spécifique est plus que bien venu se pose de manière très générale le problème de l'encombrement. La majeure partie des "amplis lignes" sont de dimensions importante et nécessite d'être monté habituellement dans une armoire technique.

Il est aussi connu en électronique basses fréquences appliquée à l'audio que la qualité de la tension d'alimentation influe grandement sur la qualité du signal basses fréquences traité. Il est aussi connu que les tubes électroniques nécessitent une haute tension de fonctionnement, de plusieurs centaines de volts et sous des courants assez faibles. Couramment la haute tension continue nécessaire a leur fonctionnement est produite par un dispositif d'alimentation élévateur / redresseur / filtre de tension. Il s'agit classiquement d'un dispositif mettant en oeuvre un transformateur, un pont de diodes et un condensateur, alimenté par la tension alternative du réseau EDF (à une fréquence de 50 hertz). Or le parfait filtrage de l'ondulation résiduelle après redressement de la tension alternative du secteur étant impossible, il en résulte une «pollution» de la haute tension continue appliquée généralement aux anodes des tubes électroniques par la superposition d'une ondulation résiduelle à la fréquence de 100 hertz. Celle ci est issue de la tension d'alimentation. Il s'en suit que cette ondulation résiduelle se retrouve en partie non négligeable sur le signal audio basses fréquences traité par le dispositif amplificateur, alimenté par le dispositif d'alimentation précédemment décrit. On remarque aussi une tendance des dispositifs de redressement / filtrage des tensions d'alimentations, généralement composés d'éléments résistifs et capacitifs, à limiter l'aptitude des dispositifs de traitement du signal audio qu'ils alimentent à reproduire sans distorsions et sans atténuations les fréquences graves du fait de leur forte impédance de sortie..

Enfin, dans le cas des ordinateurs et des stations multimédia audio vidéo en particulier, le signal basses fréquences est tout d'abord codé en numérique puis est décodé en analogique par un ensemble qui est communément dénommé «carte son». Dans cet ensemble l'étage de sortie de la "carte son" vers les autres maillons de la chaîne de traitement du signal qui est généralement réalisé autour d'un amplificateur opérationnel, donne un confort d'écoute très dégradé se traduisant par une musicalité «sèche» plutôt désagréable pour l'oreille humaine , dû notamment au fait que certains groupes d'harmoniques à dominantes impaires sont favorisés.

Le but de l'invention est de pallier les inconvénients précités. A cet effet, l'invention a pour objet, un dispositif amplificateur à tube électronique pour l'amplification de signaux audio circulant sur une ligne de transmission reliant un dispositif d'émission à au moins un dispositif de réception, le dispositif étant interposé sur la ligne entre le dispositif d'émission et le dispositif de réception, caractérisé en ce qu'il comprend un module amplificateur à tube électronique à grande impédance d'entrée et faible impédance de sortie, couplé à un étage élévateur de tension alimenté par un module régulateur à découpage dont la fréquence est supérieure et en dehors de la bande de fréquence du signal audio.

De préférence, les éléments du dispositif préamplificateur composés du module amplificateur à tube électronique ainsi que de l'étage élévateur de tension et du module régulateur à découpage étant incorporés dans un même boîtier.

L'invention a également pour objet une carte son d'ordinateur comportant une carte mère caractérisée en ce qu'elle comprend un module amplificateur à tube électronique à grande impédance d'entrée et faible impédance de sortie, et un étage élévateur de tension couplé à un module régulateur à découpage(8) également disposé sur la carte son et dont la fréquence est supérieure et en dehors de la bande de fréquence du signal audio, et en ce que l'entrée et la sortie du module amplificateur sont couplées à un bus de communication analogique, en ce que l'entrée du module amplificateur est également couplée à la sortie d'un convertisseur numérique analogique pour convertir en signaux analogiques des signaux numériques fournis par la carte mère de l'ordinateur, et en ce que la sortie du module amplificateur est également couplée à un convertisseur analogique numérique pour fournir à la carte mère de l'ordinateur les signaux obtenus en sortie du préamplificateur sous une forme numérique.

Le dispositif selon l'invention a pour principal avantage qu'il permet d'adapter l'impédance entre "émetteur" et "récepteur" en présentant à "l'émetteur" une impédance très élevée, supérieure à 10 mégohms et en présentant au "récepteur" une impédance très basse d'une centaine d'ohms, portant ainsi le rapport impédance d'entré / impédance de sortie à une valeur couramment supérieure à 100 000.

Il a également pour avantage qu'étant alimenté par une haute tension issue d'un régulateur à découpage alimentant un montage élévateur de tension comme une pompe de charge ou un transformateur et fonctionnant à une fréquence supérieure à la limite supérieure du spectre audible, il échappe au problème de pollution du signal audio dans la partie audible du spectre ainsi qu'a celui de l'inaptitude de reproduction des basses fréquences. En effet dans le cas du dispositif décrit dans le cadre de cette invention, la fréquence fondamentale de l'ondulation résiduelle étant supérieure à la limite du spectre audible d'un individu moyen, il n'est pas à craindre de pollution sensible pour l'oreille humaine dans la bande audible du spectre c'est à dire entre 20 hertz et 20000 hertz. De plus, l'impédance de sortie de l'alimentation haute fréquence est très basse par rapport à son homologue basse fréquence.

D'autre part en étant alimenté par une alimentation à découpage de petite dimension le dispositif selon l'invention peut prendre place dans un boîtier de la taille d'un paquet de cigarettes cartonné, l'entrée du signal audio basses fréquences se faisant à l'une des extrémités du boîtier aménagée en "entrée audio" et la sortie se faisant à l'autre, aménagée en "sortie audio". Eventuellement, il est également possible d'intégrer l'alimentation à l'intérieur de la même enceinte que celle qui entoure les électrodes du tube amplificateur. Ainsi le dispositif est prévu pour être disposé en ligne sur le trajet du signal ce qui ne nécessite pas d'installation fixe particulière ni de mise en rack.

Le dispositif suivant l'invention peut également s'ajouter en série et/ou se substituer aux étages de sortie des cartes son des ordinateurs en réalisant l'adaptation d'impédance, jusqu'alors généralement effectuée par des dispositifs à semiconducteurs indifféremment intégrés ou non, grâce à un dispositif à tube électronique, composant connu par les amateurs "audiophiles" pour sa capacité à favoriser certains groupes d'harmoniques à dominantes paires, procurant à "l'écoute" une sensation d'ouverture, de douceur, et d'aération du message musical propres aux électroniques à tubes.

D'autres caractéristiques et avantages de l'invention apparaîtront à l'aide de la description qui suit faite en regard des dessins annexés qui représentent:
La figure 1 une chaîne de traitement d'un signal audio incorporant un dispositif selon l'invention
La figure 2 un schéma simplifié d'un mode de réalisation d'un dispositif selon l'invention.

Les figures 3 et 4 un mode de couplage du dispositif selon l'invention à une chaine de transmission de signaux audio fréquences.

La figure 5 un mode de réalisation détaillé d'un dispositif selon l'invention.

La figure 6 un exemple d'application d'un dispositif selon l'invention à la réalisation d'une carte son d'un ordinateur.

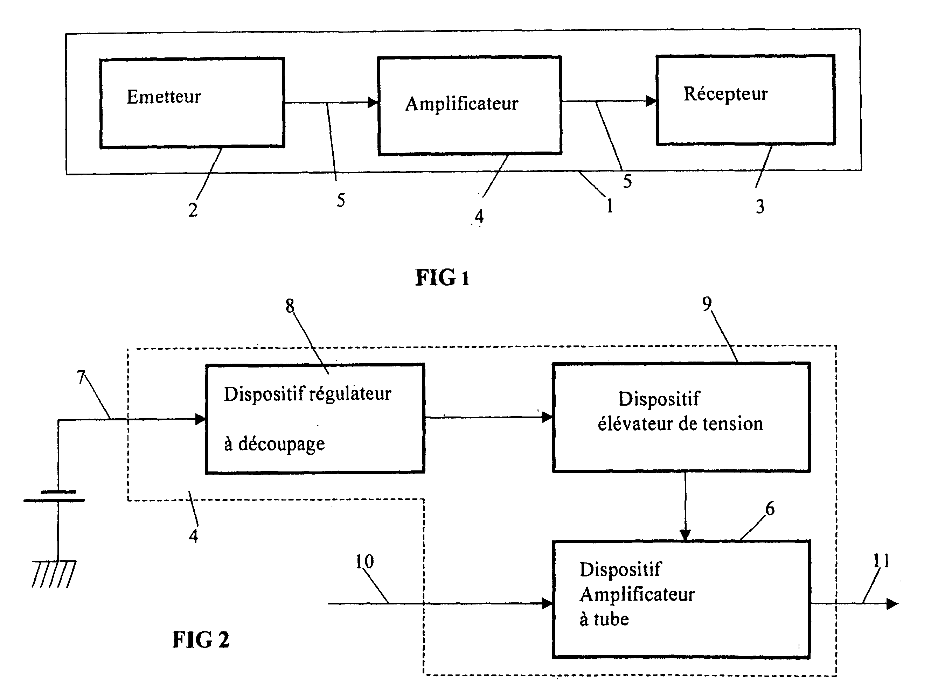

Dans le schéma synoptique FIG 1 est représenté de manière très générale la chaîne de traitement (1) du signal analogique audio basses fréquences couramment rencontrée dans les différentes applications qui vont être décrites. L'émetteur» (2) représente toute source analogique d'impédance de sortie variable ou interface basses fréquences dans lesquelles ou desquelles transitent ou sont émis des signaux basses fréquences soit par exemple un lecteur de compact disque, un lecteur de cassette audio digitale (DAT), un lecteur de minidisque un lecteur de cassette analogiques, une platine vinyle, une carte son d'ordinateur, une console de mixage, un dispositif d'effet audio, un dispositif de compression, un microphone d'enregistrement, une «boite de direct», un combiné autoradio,..Le récepteur(3) désigne de manière toute aussi générale n'importe quel maillon audio intermédiaire à impédance d'entrée variable recevant ou se faisant traverser par un signal basse fréquence issue d'un émetteur source: il peut s'agir d'un amplificateur basse fréquence de puissance, d'un amplificateur, d'une "boite de direct", d'une enceinte amplifiée d'ordinateur ou de contrôle, d'une table de mixage, de l'entrée d'un carte d'acquisition sonore d'ordinateur... La référence (5) désigne les liaisons câblées reliant les différents maillons analogiques de la chaîne de traitement du signal basses fréquences. Le dispositif selon l'invention (4) s'intercale en ligne sur le trajet du signal audio basses fréquences entre "l'émetteur" et le "récepteur".

Le synoptique de la FIG 2 fait apparaître les différents sous-ensembles constitutifs de l'invention. Un dispositif amplificateur à tube électronique (6) est alimenté en haute tension continue produite par l'application d'une basse tension continue (7) sur un dispositif intégré de régulation à découpage de fréquence de fonctionnement élevée (8) alimentant un dispositif élévateur de tension (9). Dans ce mode particulier de réalisation, le signal audio basses fréquences est appliqué en entrée du dispositif amplificateur (10) sur la grille du tube électronique situés au sein du dispositif (6) puis "ressort" une fois la amplification effectuée par le montage, par la cathode du tube à vide (11).

Le dispositif étant alimenté par une haute tension issue du régulateur à découpage (8) alimentant l'étage élévateur de tension (9) comme une pompe de charge ou un transformateur et fonctionnant à une fréquence d'au moins 25 fois la limite supérieure du spectre audible (soit 25 fois 20 kilo-hertz), échappe au problème de pollution du signal audio dans la partie audible du spectre ainsi qu'à celui de l'inaptitude de reproduction des basses fréquences. En effet, dans le cas du dispositif décrit dans le cadre de cette invention, la fréquence fondamentale de l'ondulation résiduelle se situant à 500 kilo hertz, il n'est pas à craindre de pollution sensible pour l'oreille humaine dans la bande audible du spectre c'est à dire entre 20 hertz et 20 000 hertz, d'ou un accroissement sensible de la dynamique du signal traité ainsi qu'un recul du niveau de bruit de quelque décibels.

Afin de mieux expliquer l'utilité et le fonctionnement de l'invention, un mode particulier de réalisation destiné aux stations informatiques audio vidéo est décrit ci- après :

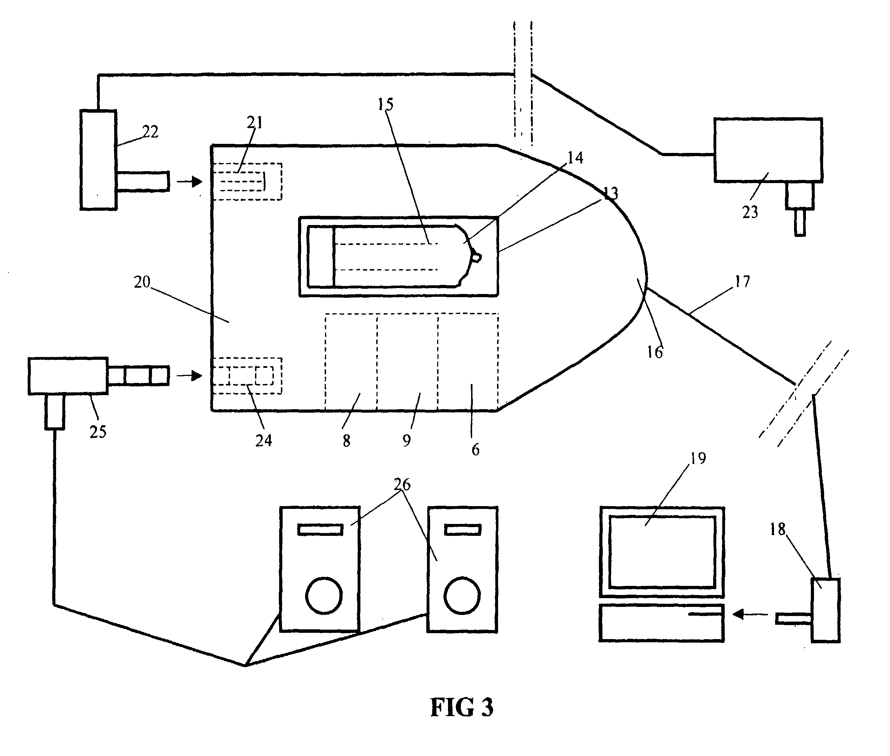

Selon le mode particulier de réalisation décrit sur la FIG 3, le dispositif régulateur à découpage (8), le dispositif élévateur de tension (9) et le dispositif préamplificateur audio (6), prennent place dans un boîtier de petite dimension (12). Une partie de ce boîtier est évidée (13) afin de laisser apparaître le tube électronique (14), laissant filtrer le rougeoiement des filaments (15). L'extrémité (16) du boîtier (12) est prolongée par un câble blindé (17) à deux conducteurs dans ce mode particulier de réalisation, amovibles ou non via un connecteur, à l'extrémité duquel se trouve un connecteur de type "jack stéréo" (18) dans ce mode particulier de réalisation, destiné à être connecté aux sorties audio des ordinateurs (19) : il s'agit de l'entrée (18) du dispositif préamplificateur audio selon l'invention. A l'extrémité (20) du dispositif selon l'invention, prend place un connecteur bipolaire (21) destiné à recevoir le connecteur amovible (22) issu d'un dispositif abaisseur de tension (23) connectable au secteur dans ce mode particulier de réalisation et faisant office de source de tension : il s'agit du dispositif alimentant le dispositif selon l'invention. A l'extrémité (20) prend aussi place un connecteur (24) stéréophonique : il s'agit de la sortie du dispositif préamplificateur audio décrit selon l'invention. Un connecteur amovible de type "jack stéréophonique " (25) dans ce mode particulier de réalisation se connecte sur (24). Il (25) relie la sortie (24) du système selon l'invention aux enceintes acoustiques de contrôle (26) le suivant.

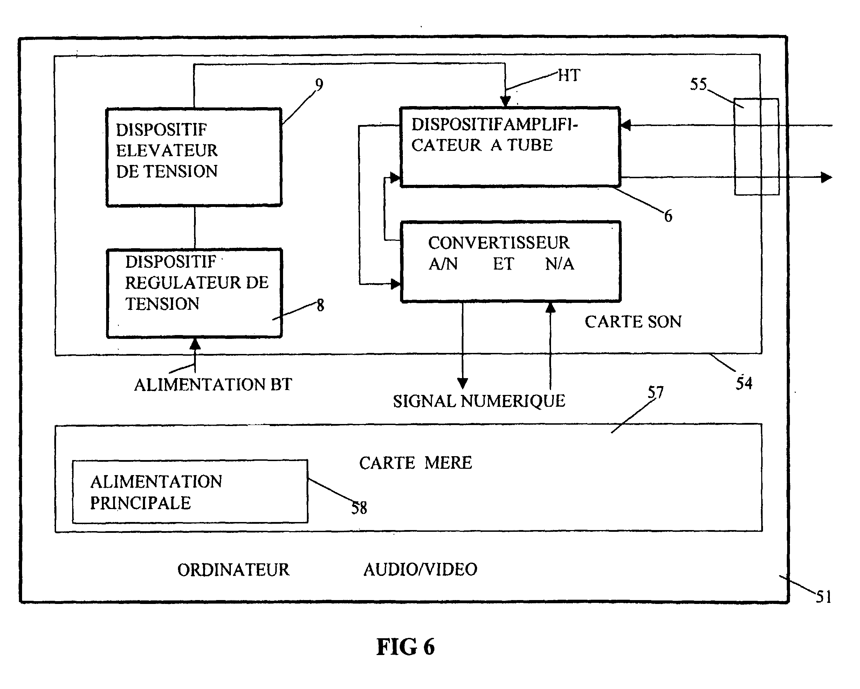

Le fonctionnement du circuit d'alimentation de la FIG 5 va maintenant être décrit. La basse tension d'alimentation issue du dispositif abaisseur (23) est appliquée sur la broche (27) du régulateur à découpage intégré (28), une tension commutée haute fréquence est produite par l'oscillateur interne du régulateur (28) et est disponible sur la broche (29).La self (30) sert au stockage du courant. La tension disponible en (29) est alors appliquée à un dispositif élévateur de tension externe (32),dans ce mode particulier de réalisation, une pompe de charge multiplicatrice de tension composée diode de commutation/capacité. Ce multiplicateur de tension peut tout aussi bien être remplacé par un transformateur ou un montage de fonction équivalente éventuellement un transistor supportant les hautes tensions. En sortie de la pompe de charge (33) une capacité (37) fixe le potentiel de la haute tension nouvellement élevé et un pont diviseur constitué des résistances (35) et (35) ramène une partie de la tension de sortie du dispositif élévateur sur la broche de contre réaction (36) du régulateur à découpage (28), fixant ainsi la tension commutée disponible en sortie de la première diode (31) à son maximum, nécessairement supérieur de quelques volts à la tension d'alimentation appliquée en (27). Une capacité (38) stabilise le potentiel disponible sur la cathode de la première diode du dispositif élévateur au point (31). Le potentiel de la haute tension de plusieurs centaines de volts est stabilisé en sortie du dispositif élévateur de tension par la capacité (37). La haute tension disponible en (33) est appliquée, dans ce mode particulier de réalisation en (39) aux anodes des tubes électroniques composant le dispositif de traitement du signal audio basses fréquences.

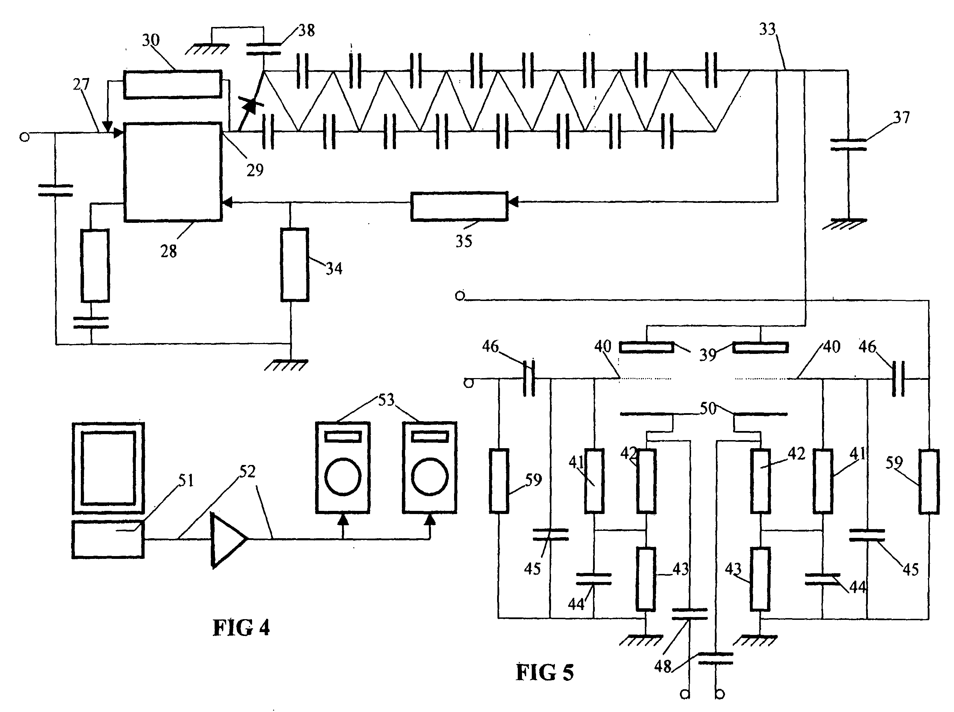

Le fonctionnement de la partie dédiée FIG 5 au traitement du signal audio va être décrit dans le paragraphe ci-dessous. Il s'agit, dans ce mode particulier de réalisation d'un suiveur cathodique réalisé à partir de tubes électroniques doubles triodes. Du point de vue statique la haute tension de quelques centaines de volts est appliquée sur les anodes (39) des tubes électroniques. Les grilles(40) des tubes électroniques sont polarisées suivant les recommandations de mise en oeuvre spécifiques aux types de tubes électroniques utilisés. Cette polarisation par rapport aux cathodes (41) est effectuée grâce au réseau de résistances (41), (42), (43). Les capacités (44)et(45) éliminent un léger "bruit" résiduel de l'alimentation à découpage, décelable à l'oscilloscope. La capacité d'entée (46), en série sur le trajet du signal basse fréquence isole le maillon connecté en (47) de la tension continue présente sur la grille en (40). La résistance (59) positionne l'entrée du montage par rapport à la masse. La capacité (48) isole les dispositifs connectés à la sortie du montage (49) de la haute tension présente sur les cathodes (50). En alternatif, le fonctionnement du dispositif, suiveur cathodique dans ce mode particulier de réalisation est le suivant : Le signal audio basses fréquences, assimilable à une tension alternative est appliqué en entrée (47 ) où il traverse la capacité (46), perméable en alternatif, pour engendrer des variations de potentiel sur la grille (40) du tube électronique. La modulation du potentiel de grille engendre une variation du courant cathodique. Le signal, ayant subi l'amplification en courant est prélevé sur la cathode (50) au moyen du condensateur (48). L'armature au plus bas potentiel du condensateur (48) est reliée à la sortie (24) de la FIG 3 du dispositif selon l'application particulière de l'invention. Il s'agit de la sortie audio du dispositif amplificateur. La FIG 4 précise la place prise par le dispositif selon l'invention précédemment décrit, dans le cas de son insertion dans une chaîne de traitement du signal audio basses fréquences, constituée d'un ordinateur (51) de câbles (52) et d'une paire d'enceintes amplifiées (53).Le signal audio basses fréquences issue de la "carte son" de l'ordinateur est destiné à moduler les enceintes amplifiées. Il traverse le dispositif qui selon l'invention, présente à "l'émetteur" c'est à dire la "carte son " de l'ordinateur une impédance d'entrée très élevée et présente au "récepteur" c'est à dire les enceintes acoustiques dans ce mode particulier de mise en oeuvre une impédance de sortie très basse. Il est à noter que le dispositif selon l'invention aurait tout aussi bien pu être inséré entre un dispositif d'acquisition comme un microphone par exemple et l'étage d'entrée de la "carte son".

Suivant un autre mode particulier de réalisation le dispositif selon l'invention peut être intégré aux "cartes son" des ordinateurs pourvu d'interfaces audio / vidéo. Le schéma visible sur la FIG 6 représente l'organigramme des différents sous ensembles du dispositif qui va être décrit dans les lignes suivantes. La partie de l'ordinateur audio / vidéo (51) dénommée "carte son" (54) est un sous ensembles destiné, via un bus de communication (55), à permettre l'acquisition et la restitution par l'ordinateur de données analogiques comme des signaux audio basses fréquences dans le dispositif qui nous préoccupe : Les "cartes sons" permettent la communication de l'extérieur vers l'intérieur de l'ordinateur et réciproquement. Le sous ensemble (56) est un convertisseur réversible numérique / analogique et analogique / numérique. Il a, dans un sens, de l'intérieur de la carte mère (57) de l'ordinateur hôte de la "carte son" (54) vers l'extérieur, pour fonction la conversion en signaux analogiques de grandeurs numériques codant des variations d'intensité en fonction de la fréquence, caractéristiques des signaux audio basses fréquences traité. Il a, dans l'autre sens, pour fonction le codage en signaux numérique des signaux audio basses fréquences analogiques issu des divers dispositifs d'acquisitions.

Le dispositif (6) est le sous ensemble amplificateur à tubes électroniques qui traite le signal audio issu du dispositif convertisseur(56).Le dispositif amplificateur(6) étant le dernier dispositif traversé par le signal audio basses fréquences, est appelé "étage de sortie de la carte son". Les anodes des tubes électroniques composant le dispositif préamplificateur (6), sont alimentées par une haute tension de plusieurs centaines de volts issue du dispositif élévateur de tension (9) lui même alimenté par le régulateur à découpage représenté en (8). Le régulateur à découpage peut être de manière non limitative alimenté par une basse tension continue ou non prélevée sur l'alimentation principale (58) de l'ordinateur hôte (53). Le fonctionnement du point de vue du traitement du signal audio du système représenté sur la figure 6 est le suivant. Lors d'un processus d'acquisition, le signal analogique audio basses fréquences est appliqué à la carte son (54) via le bus (55). Il attaque le dispositif amplificateur à tube adaptateur d'impédance (6) "intégré à la carte son". Le signal ,une fois pré amplifié par (6) est codé en numérique par le convertisseur (56). Une fois au format numérique, il est ensuite traité par la carte mère de l'ordinateur hôte. Lors d'un processus de restitution le signal audio numérique est tout d'abord converti en signal audio basses fréquences par le convertisseur (56). Le signal est ensuite pré amplifié par le dispositif selon l'invention (6) puis disponible sous forme analogique en sortie de la carte son, c'est à dire sur le bus (55).

Une autre application spécifique aux automobiles est brièvement décrite dans les lignes suivantes. En effet dans les véhicules terrestres les longueurs de câble posent de sensibles problèmes d'adaptation d'impédances. Les longueurs importantes de câble de modulation, inhérentes aux installations audio mobiles, ne constituent plus un handicap quelque soit la localisation des maillons de la chaîne de reproduction. En amont, l'impédance d'entrée très élevée du dispositif selon l'invention permet à la source, (lecteur de "compact disque"...) de s'exprimer plus librement, comme si elle fonctionnait sans charge.

En aval, sa basse impédance de sortie lui permet d'attaquer en "courant" un amplificateur même éloigné. De plus dans l'application décrite ici il remplace avantageusement l'étage de sortie de tout convertisseur en substituant notamment à son atténuateur numérique un potentiomètre analogique motorisé. Le dispositif selon l'invention fonctionne en étant alimenté par la batterie du véhicule.

L'invention n'est pas limitée aux modes de réalisations qui viennent d'être décrits, notamment d'autres variantes de réalisation sont encore possibles. Par exemple, selon une première variante de réalisation l'alimentation à découpage et le dispositif élévateur de tension qui lui est associé peuvent être aussi bien intégrés dans une pastille recevant le brochage du tube amplificateur et s'enfichant dans une pièce support de tube en étant interposé entre le brochage du tube et la pièce support. Dans ce cas on pourra avantageusement utiliser la tension d'alimentation du filament du tube comme tension d'alimentation de l'alimentation à découpage.

Selon une deuxième variante de réalisation les dispositifs d'alimentation à découpage et élévateurs de tension pourront être intégrés dans l'enceinte qui entoure les électrodes du tube.

## Revendications

1. Dispositif amplificateur à tube électronique pour l'amplification de signaux audio circulant sur une ligne de transmission reliant un dispositif d'émission (2) à au moins un dispositif de réception (3), le dispositif étant interposé sur la ligne entre le dispositif d'émission(2) et le dispositif de réception (3), **caractérisé en ce qu'**il comprend un module amplificateur à tube électronique(6) à grande impédance d'entrée et faible impédance de sortie, couplé à un étage élévateur de tension(9) alimenté par un module régulateur à découpage(8) dont la fréquence est supérieure et en dehors de la bande de fréquence du signal audio.

2. Dispositif selon la revendication 1 **caractérisée en ce que** les éléments du dispositif amplificateur composés du module amplificateur à tube électronique (6) ainsi que de l'étage élévateur de tension (9) et du module régulateur à découpage (8) étant incorporés dans un même boîtier (12).

3. Dispositif selon la revendication 1 ou 2 **caractérisé en ce que** le dispositif élévateur de tension(9) est un transformateur.

4. Dispositif selon la revendication 1 **caractérisé en ce que** le dispositif élévateur de tension est un transistor haute tension.

5. Dispositif selon la revendication 1 **caractérisé en ce que** le dispositif élévateur de tension est un circuit pompe de charge.

6. Dispositif selon l'une quelconque des revendications 1 a 5 **caractérisé en ce que** la fréquence du module régulateur à découpage(8) est supérieure 500 kHz.

7. Dispositif selon l'une quelconque des revendications 1 à 6 **caractérisé en ce que** le module amplificateur à tube électronique (6) est formé par un étage à cathode suiveuse.

8. Dispositif selon la revendication 7 **caractérisé en ce que** l'étage à cathode suiveuse (6) est formé par deux triodes à cathode suiveuse, et **en ce que** le signal audio est appliqué entre les deux grilles (40) des triodes et est prélevé après avoir été amplifié par les deux triodes entre les deux cathodes (41) des deux triodes.

9. Dispositif selon la revendication 8 **caractérisé en ce que** l'étage à cathode suiveuse est formé par yun seul tube à double triodes.

10. Dispositif selon l'une quelconque des revendications 1 à 9 **caractérisé en ce que** le dispositif élévateur de tension (9) fournit une tension stabilisée relativement à une tension d'alimentation continue de référence (7) appliquée à l'entrée du module régulateur à découpage (8).

11. Dispositif selon la revendication 10 **caractérisé en ce que** la tension fournie par le dispositif élévateur de tension est appliquée sur les anodes (39) des triodes

12. Dispositif selon la revendication 10 **caractérisé en ce que** la tension d'alimentation continue de référence est fournie par le dispositif d'émission.

13. Dispositif selon la revendication 10 **caractérisé en ce que** la tension d'alimentation continue de référence est fournie par un dispositif abaisseur de tension (23) relié au secteur.

14. Dispositif selon l'une quelconque des revendications 1 à 13 **caractérisé en ce que** le module régulateur à découpage (8) et l'étage élévateur de tension (9) sont intégrés dans une pastille recevant le brochage du tube du module amplificateur et s'enfichant dans une pièce support de tube en étant interposé entre le brochage du tube et la pièce support.

15. Dispositif selon l'une quelconque des revendications 1 à 13 **caractérisé en ce que** le module régulateur à découpage (8) et l'étage élévateur de tension (9) sont intégrés à l'intérieur de l'enceinte du tube composant le module amplificateur (6).

16. Carte son d'ordinateur comportant une carte mère (57) **caractérisée en ce qu'**elle comprend un module amplificateur à tube électronique(6) à grande impédance d'entrée et faible impédance de sortie, et un étage élévateur de tension(9)
couplé à un module régulateur à découpage(8) également disposé sur la carte son et dont la fréquence est supérieure et en dehors de la bande de fréquence du signal audio, et **en ce que** l'entrée et la sortie du module amplificateur (6) sont couplées à un bus (55) de communication analogique, **en ce que** l'entrée du module amplificateur (6) est également couplée à la sortie d'un convertisseur numérique analogique(56) pour convertir en signaux analogiques des signaux numériques fournis par la carte mère (57) de l'ordinateur, et **en ce que** la sortie du module amplificateur (6) est également couplée à un convertisseur analogique numérique (56) pour fournir à la carte mère (57) de l'ordinateur les signaux obtenus en sortie du module amplificateur (6) sous une forme numérique.

## Patentansprüche

1. Verstärkungsvorrichtung mit Elektronenröhre zum Verstärken von Audiosignalen, die auf einer Übertragungsleitung zirkulieren, die eine Sendevorrichtung (2) mit mindestens einer Empfangsvorrichtung (3) verbindet, wobei die Vorrichtung auf der Leitung zwischen der Sendevorrichtung (2) und der Empfangsvorrichtung (3) eingefügt ist, **dadurch gekennzeichnet, dass** sie ein Verstärkungsmodul mit Elektronenröhre (6) mit großer Eingangsimpedanz und schwacher Ausgangsimpedanz umfasst, das mit einer Spannungserhöhungsstufe (9), die von einem Regelmodul mit Zerhacken (8) versorgt wird, dessen Frequenz größer und außerhalb des Frequenzbands des Audiosignals ist, gekoppelt ist.

2. Vorrichtung nach Anspruch 1, **dadurch gekennzeichnet, dass** die Elemente der Verstärkungsvorrichtung, die aus dem Verstärkungsmodul mit Elektronenröhre (6) sowie der Spannungserhöhungsstufe (9) und dem Regelmodul mit Zerhacken (8) bestehen, in das gleiche Gehäuse (12) eingebaut sind.

3. Vorrichtung nach Anspruch 1 oder 2, **dadurch gekennzeichnet, dass** die Spannungserhöhungsvorrichtung (9) ein Transformator ist.

4. Vorrichtung nach Anspruch 1, **dadurch gekennzeichnet, dass** die Spannungserhöhungsvorrichtung ein Hochspannungstransistor ist.

5. Vorrichtung nach Anspruch 1, **dadurch gekennzeichnet, dass** die Spannungserhöhungsvorrichtung ein Lastpumpschaltkreis ist.

6. Vorrichtung nach einem der Ansprüche 1 bis 5, **dadurch gekennzeichnet, dass** die Frequenz des Regelmoduls mit Zerhacken (8) höher ist als 500 kHz.

7. Vorrichtung nach einem der Ansprüche 1 bis 6, **dadurch gekennzeichnet, dass** das Verstärkungsmodul mit Elektronenröhre (6) aus einer Stufe mit Folgerkathode gebildet wird.

8. Vorrichtung nach Anspruch 7, **dadurch gekennzeichnet, dass** die Stufe mit Folgerkathode (6) von zwei Trioden mit Folgerkathode gebildet wird, und dadurch, dass das Audiosignal zwischen den zwei Gittern (40) der Trioden angelegt wird und nach dem Verstärken durch die zwei Dioden zwischen den zwei Kathoden (41) der zwei Trioden abgegriffen wird.

9. Vorrichtung nach Anspruch 8, **dadurch gekennzeichnet, dass** die Stufe mit Folgerkathode aus einer einzigen Röhre mit doppelten Trioden gebildet wird.

10. Vorrichtung nach einem der Ansprüche 1 bis 9, **dadurch gekennzeichnet, dass** die Spannungserhöhungsvorrichtung (9) eine in Bezug auf eine Referenzversorgungsgleichspannung (7), die an den Eingang des Regelmoduls mit Zerhacken (8) angelegt wird, stabilisierte Spannung liefert.

11. Vorrichtung nach Anspruch 10, **dadurch gekennzeichnet, dass** die von der Spannungserhöhungsvorrichtung gelieferte Spannung an die Anoden (39) der Trioden angelegt wird.

12. Vorrichtung nach Anspruch 10, **dadurch gekennzeichnet, dass** die Referenzversorgungsgleichspannung von der Sendevorrichtung geliefert wird.

13. Vorrichtung nach Anspruch 10, **dadurch gekennzeichnet, dass** die Referenzversorgungsgleichspannung von einer Spannungsverringerungsvorrichtung (23) geliefert wird, die an den Netzstrom angeschlossen ist.

14. Vorrichtung nach einem der Ansprüche 1 bis 13, **dadurch gekennzeichnet, dass** das Regelmodul mit Zerhacken (8) und die Spannungserhöhungsstufe (9) in ein Lötauge eingebaut sind, das die Stiftverbindung der Röhre des Verstärkungsmoduls erhält, und in ein Röhrentragteil gesteckt wird, wobei sie zwischen der Stiftverbindung der Röhre und dem Tragteil eingefügt ist.

15. Vorrichtung nach einem der Ansprüche 1 bis 13, **dadurch gekennzeichnet**, das das Regelmodul mit Zerhacken (8) und die Spannungserhöhungsstufe (9) im Inneren der Umschließung der Röhre eingebaut sind, die das Verstärkungsmodul (6) bildet.

16. Computer-Soundkarte mit einer Hauptplatine (57), **dadurch gekennzeichnet, dass** sie ein Verstärkungsmodul mit Elektronenröhre (6) mit großer Eingangsimpedanz und schwacher Ausgangsimpedanz und eine Spannungserhöhungsstufe (9) umfasst, gekoppelt mit einem Regelmodul mit Zerhacken (8), das ebenfalls auf der Soundkarte angeordnet ist und dessen Frequenz größer und außerhalb des Frequenzbands des Audiosignals ist, und dadurch, dass der Eingang und der Ausgang des Verstärkungsmoduls (6) an einen Bus (55) zur Analogkommunikation gekoppelt sind, und dadurch, dass der Eingang des Verstärkungsmoduls (6) auch an den Ausgang eines Digital-Analog-Wandlers (56) gekoppelt ist, um die digitalen Signale, die von der Hauptplatine (57) des Computers geliefert werden, in analoge Signale umzuwandeln, und dadurch, dass der Ausgang des Verstärkungsmoduls (6) auch mit einem Analog-Digital-Wandler (56) gekoppelt ist, um der Hauptplatine (57) des Computers die Signale zu liefern, die am Ausgang des Verstärkungsmoduls (6) in einer digitalen Form erhalten werden.

## Claims

1. Electronic tube amplifier device for amplifying audio signals circulating on a transmission line connecting a transmission device (2) to at least one receiving device (3), the device being inserted on the line between the transmission device (2) and the receiving device (3), **characterised in that** it includes an electronic tube amplifier module (6) with high input impedance and low output impedance coupled to a voltage booster stage (9) fed by a cutoff regulator module (8) whose frequency is greater than and outside the frequency band of the audio signal.

2. Device according to claim 1, **characterised in that** the elements of the amplifier device composed of the electronic tube amplifier module (6) and the voltage booster stage (9) and the cutoff regulator module (8) are incorporated in a given box (12).

3. Device according to claim 1 or 2, **characterised in that** the voltage booster device (9) is a transformer.

4. Device according to claim 1, **characterised in that** the voltage booster device is a high voltage transistor.

5. Device according to claim 1, **characterised in that** the voltage booster device is a charge pump circuit.

6. Device according to one of claims 1 to 5, **characterised in that** the frequency of the cutoff regulator module (8) is greater than 500 kHz.

7. Device according to one of claims 1 to 6, **characterised in that** the electronic tube amplifier module (6) is formed by a tracker cathode stage.

8. Device according to claim 7, **characterised in that** the tracker cathode stage (6) is formed by two tracker cathode triodes, and **in that** the audio signal is applied between the two grids (40) of the triodes and is taken after having been amplified by the two triodes between the two cathodes (41) of the two triodes.

9. Device according to claim 8, **characterised in that** the tracker cathode stage is formed by a single tube with double triodes.

10. Device according to one of claims 1 to 9, **characterised in that** the voltage booster device (9) provides a stabilised voltage relatively to a d.c. reference supply voltage (7) applied to the input of the cut-off regulator module (8).

11. Device according to claim 10, **characterised in that** the voltage provided by the voltage booster device is applied to the anodes (39) of the triodes.

12. Device according to claim 10, **characterised in that** the reference d.c. supply voltage is provided by the transmission device.

13. Device according to claim 10, **characterised in that** the reference d.c. mains voltage is provided by a voltage reducing device (23) connected to the mains supply.

14. Device according to one of claims 1 to 13, **characterised in that** the cut-off regulator module (8) and the voltage booster stage (9) are integrated in a pellet receiving the broaching of the tube of the amplifier module and being plugged into a tube support piece on being inserted between the broaching of the tube and the support piece.

15. Device according to one of claims 1 to 13, **characterised in that** the cut-off regulator module (8) and the voltage booster stage (9) are integrated inside the speaker of the tube composing the amplifier module (6).

16. Computer sound card comprising a mother card (57), **characterised in that** it includes an amplifier module with an electronic tube (6) with a high input impedance and a low output impedance, and a voltage booster stage (9) coupled to a cut-off regulator module (8) also placed on the sound card and whose frequency is greater than and outside the frequency band of the audio signal, and **in that** the input and output of the amplifier module (6) are coupled to an analog communication bus (55), **in that** the input of the amplifier module (6) is also coupled to the output of an analog/digital converter (56) so as to convert into analog signals the digital signals proved by the mother card (57) of the computer, and **in that** the output of the amplifier module (6) is also coupled to an analog/digital converter (56) so as to provide the mother cards (57) of the computer with the signals obtained at the output of the amplifier module (6) in a digital form.
